# EUROPÄISCHE PATENTSCHRIFT

(11) **EP 0 821 243 B1**
(45) Veröffentlichungstag und Bekanntmachung des Hinweises auf die Patenterteilung: **06.10.2004**
(21) Anmeldenummer: 97111819.5
(22) Anmeldetag: 11.07.1997
(51) Int. Cl.: G01R 31/02

(54) **Verfahren zur Prüfung des korrekten Anschlusses einer Impedanz an eine Brückenendstufe und Anordnung dazu**
Test method of the correct connection of an impedance to a bridge output stage and related apparatus
Procédé de test de la bonne connection d'une impédance à un étage de sortie en pont et dispositif associé

(30) Priorität: 24.07.1996 DE 19629781
(43) Veröffentlichungstag der Anmeldung: 28.01.1998
(73) Patentinhaber: ROBERT BOSCH GMBH, 70442 Stuttgart (DE)
(72) Erfinder: Markert, Siegfried, 31180 Giesen (DE); Loehr, Achim, 31139 Hildesheim (DE)

(56) Entgegenhaltungen:
- EP-A- 0 365 697
- WO-A-88/00770
- DE-A- 3 842 169
- DE-U- 29 514 157

## Beschreibung

### Stand der Technik

Die Erfindung geht von einem Verfahren und einer Anordnung zur Überprüfung des korrekten Anschlusses einer Last, insbesondere eines Lautsprechers, an eine Brückenendstufe nach der Gattung der unabhängigen Ansprüche aus.

Aus der DE 38 42 169 A1 ist eine Schaltungsanordnung mit einer Feldeffekt-Transistor-Endstufe zum Ein- und Ausschalten eines Verbrauchers bekannt, die mit einer Überwachungsschaltung zur Auslösung von Signalen bei Kurzschluss sowie Leitungsunterbrechungen im Verbraucherstromkreis versehen ist.

### Vorteile der Erfindung

Das erfindungsgemäße Verfahren und die erfindungsgemäße Anordnung haben den Vorteil, dass auf einfache Weise der korrekte Anschluss einer Impedanz an eine Brückenendstufe überprüfbar ist. Des weiteren ist es vorteilhaft, dass die Überprüfung des Impedanzanschlusses außerhalb des normalen Betriebszustandes, also beispielsweise vor der Inbetriebnahme der Brückenendstufe möglich ist. Dies ist beispielsweise beim Anschluß eines Lautsprechers an ein Autoradio am Montageband eines Kfz-Herstellers vorteilhaft, wo eine schnelle und zuverlässige Funktionskontrolle erwünscht ist. Durch die in den Unteransprüchen aufgeführten Maßnahmen sind vorteilhafte Weiterbildungen und Verbesserungen der in den unabhängigen Ansprüchen angegebenen Vorrichtungen und Verfahren möglich. Eine einfache Möglichkeit zur Auslösung des erfindungsgemäßen Prüfverfahrens ist gemäß Anspruch 2 dadurch gegeben, daß das Ungleichgewicht der Brückendiagonalen durch Verstellung des Arbeitspunktes einer Halbbrücke erzeugt wird. Die Absenkung des Arbeitspunktes einer Halbbrücke auf einen vorgegebenen Wert gemäß Anspruch 3 ermöglicht die Prüfung der angeschlossenen Last auch während des Betriebs der Brückenendstufe. Das Verfahren nach Anspruch 4 ermöglicht neben der Erkennung einer Unterbrechung der Anschlußleitungen auch die Detektierung weiterer Fehlerfälle, wie ein Kurzschluß der Anschlußleitungen oder zu hohe Kontaktwiderstände, die z. B. aus korrodierten Anschlußkontakten resultieren können. Die Anzeige über ein optisches Anzeigeinstrument gemäß Anspruch 5 ermöglicht die Unterscheidung verschiedener Fehlerfälle und damit die schnelle Auffindung der Fehlerursache.

### Zeichung

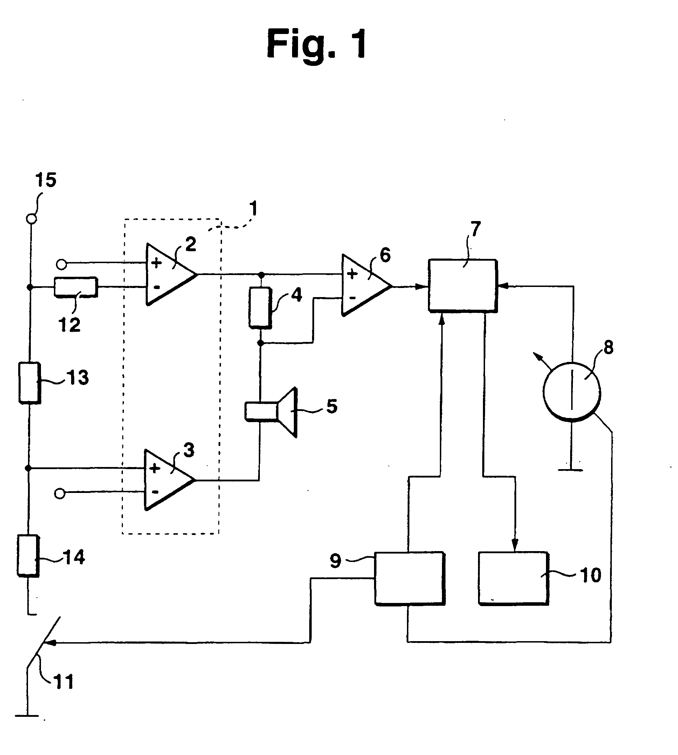

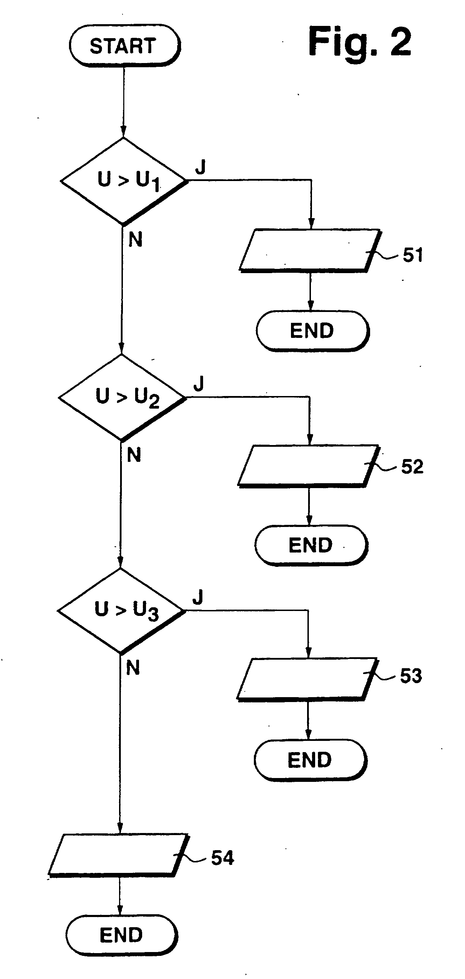

Ausführungsbeispiele der Erfindung sind in der Zeichnung dargestellt und in der nachfolgenden Beschreibung näher erläutert. Es zeigen Figur 1 eine Ausführungsform einer Anordnung zur Durchführung des erfindungsgemäßen Verfahrens und Figur 2 ein Ablaufdiagramm zur Überprüfung mehrerer möglicher Fehlerfälle.

### Beschreibung

Figur 1 zeigt schematisch eine aus zwei Verstärkern 2 und 3 bestehende Brückenendstufe 1, wie sie beispielsweise bei Autoradios als NF-Endstufe eingesetzt wird. Zwischen den Ausgängen der Verstärker 2 und 3, also in der Brückendiagonalen der Brückenendstufe 1 ist die zu prüfende Impedanz, im vorliegenden Fall des Lautsprechers 5 angeschlossen. Dem Lautsprecher 5 ist ein Meßwiderstand 4 in Serie geschaltet, dessen beide Anschlüsse darüberhinaus den Eingängen eines Subtrahierers 6 zugeführt sind. Das Ausgangssignal des Subtrahierers 6 ist dem Meßeingang eines Vergleichers 7 zugeführt, dessen Referenzeingang mit dem Ausgang einer steuerbaren Spannungsquelle 8 verbunden ist. Die steuerbare Spannungsquelle 8 wird von einer Bedieneinheit 9 angesteuert, die ihrerseits über eine Steuerleitung mit dem Vergleicher 7 verbunden ist. Eine Klemme 15 zur Einstellung des Arbeitspunktes der Verstärker 2 und 3 ist mit einer nicht dargestellten Spannungsquelle verbunden, so daß der Arbeitspunkt dem invertierenden Eingang des ersten Verstärkers 2 über einen ersten Widerstand 12 und dem nicht invertierenden Eingang des zweiten Verstärkers 3 über einen zweiten Widerstand 13 zugeführt ist. Zur Verstellung des Arbeitspunktes des zweiten Verstärkers 3 ist dessen nicht invertierender Eingang des weiteren über einen von der Eingabeeinheit 7 steuerbaren Schalter 11 und einen dazu in Serie geschalteten dritten Widerstand 14 mit einem gemeinsamen Bezugspotential, vorzugsweise dem Massepotential, verbindbar. Der Wert des abgesenkten Arbeitspunktes ergibt sich dabei aus dem durch den zweiten und den dritten Widerstand (13, 14) gebildeten Spannungsteiler.

Die Anordnung nach Figur 1 funktioniert folgendermaßen. Soll der korrekte Anschluß eines Lautsprechers 5 an die Brückenendstufe 1 überprüft werden, so erfolgt über die Eingabeeinheit 9 z. B. durch Drücken einer Taste oder Drehen eines Schalters oder automatisch beim Einschalten des Geräts eine Anweisung, worauf die Brückenendstufe 1 auf Stand-By-Betrieb geschaltet wird. In diesem Betriebszustand überträgt die Brückenendstufe 1 kein Signal. Zugleich wird der steuerbare Schalter 11 auf ein entsprechendes Signal von der Eingabeeinheit 9 hin geschlossen, so daß sich an dem nicht invertierenden Eingang des zweiten Verstärkers 3 statt des Arbeitspunktes ein gegenüber dem Arbeitspunkt reduziertes Potential entsprechend dem Spannungsteiler aus zweitem Widerstand 13 und drittem Widerstand 14 einstellt. In Folge des aus der Verstellung des Arbeitspunktes der zweiten Halbbrücke 3 resultierenden Ungleichgewichts der Brückendiagonalen ergibt sich ein Stromfluß vom Ausgang der ersten Halbbrücke 2 über den Meßwiderstand 4 und den Lautsprecher 5 zum Ausgang der zweiten Halbbrücke 3, der, da das Maß der Arbeitspunkt-Absenkung und der Meßwiderstand 4 bekannt sind, ein Maß für den Widerstand des Lautsprechers 5 darstellt. Die am Meßwiderstand 4 in Folge des Stromflusses abfallende Spannung wird mit Hilfe des Subtrahierers 6 erfaßt und dem Meßeingang des Vergleichers 7 zugeführt, der diese auf ein Signal der Bedieneinheit 9 hin mit dem von der Referenzspannungsquelle 8 zugeführten Wert vergleicht. Erkennt der Vergleicher 7 anhand des Unterschreitens der an seinem Referenzeingang anliegenden von der Referenzspannungsquelle 8 zugeführten Referenzspannung durch die am Meßeingang anliegende charakteristische Spannung, die sich durch den Stromfluß durch die effektiv an der Brückenendstufe 1 angeschlossene Impedanz einstellt, daß der Lautsprecher 5 nicht korrekt angeschlossen ist, so gibt er über die Ausgabeeinheit 10 ein Signal ab, bei dem es sich vorzugsweise um ein optisches oder akustisches Signal handelt. Weitere Fehlerfälle sind beispielsweise durch ein in einer als Mikroprozessor ausgeführten Eingabeeinheit 9 realisiertes Prüfprogramm, das später näher erläutert wird, detektierbar. So kann beispielsweise im Falle eines Kurzschlusses der Lautsprecherleitung, der an einem deutlichen Überschreiten einer von der Refernzspannungsquelle 8 zugeführten Spannung durch die am Meßeingang anstehende Spannung erkennbar ist, die Inbetriebnahme der Endstufe verhindert werden.

Im Normalbetrieb, d. h. bei Betrieb des Lautsprechers 5 ist der Schalter 11 geöffnet, und das Nutzsignal wird von der Überprüfeinrichtung unbeeinträchtigt von der Brückenendstufe 1 zur angeschlossenen Impedanz 5 übertragen.

Des weiteren ist es gemäß einer Weiterbildung der Erfindung vorgesehen, die angeschlossene Impedanz auch während des Betriebs der Brückenendstufe zu überprüfen. Dazu wird bei Auslösen des Prüfzyklus über die Bedieneinheit 9 der Schalter 11 auf ein Signal der Bedieneinheit 9 hin geschlossen und somit der Arbeitspunkt der zweiten Halbbrücke 3 abgesenkt. Um die zweite Halbbrücke während des Prüfzyklus weiter betreiben zu können, ist es erforderlich, ihren Arbeitspunkt nur geringfügig abzusenken, was durch eine entsprechende Dimensionierung des zweiten und des dritten Widerstandes, beispielsweise im Verhältnis 1:10, erreicht wird. Der durch das Ungleichgewicht der Brückendiagonale zusätzlich zum Nutzsignal durch Lastimpedanz 5 und Meßwiderstand 4 fließende, die Lastimpedanz 5 charakterisierende Gleichstrom wird mit Hilfe eines nicht gezeigten Tiefpasses aus dem Nutz-/Meßsignal-Gemisch herausgefiltert und auf oben beschriebene Weise weiter ausgewertet.

Soll die an die Brückenendstufe angeschlossene Impedanz 5 außerhalb des normalen Betriebszustandes, also im Stand-By-Betrieb der Brückenendstufe bestimmt werden, kann auch ganz auf den dritten Widerstand 14 verzichtet werden. Das in Figur 2 anhand eines Flußdiagramms dargestellte Prüfprogramm funktioniert wie folgt. Durch Drücken einer Taste oder Drehen eines Schalters an der Eingabeeinheit 9 wird das Prüfprogramm gestartet und über ein Steuersignal an der Refernzspannungsquelle 8 eine erste Referenzspannung U1 eingestellt. Die Höhe der ersten Referenzspannung U1 liegt dabei wenige Prozent über dem Wert, der sich rechnerisch aus dem Strom durch die Reihenschaltung aus der angeschlossenen Impedanz 5 und dem Meßwiderstand 4 ergibt. Überschreitet die am Meßwiderstand und damit am Meßeingang des Vergleichers 7 anliegende Spannung diesen ersten Referenzwert, so wird ein erstes Signal 51, das dem Fehlerfall Kurzschluß entspricht, über die Ausgabeeinheit 10 ausgegeben und das Prüfprogramm gestoppt. Bei Unterschreiten der ersten Referenzspannung U1 wird nach einer entsprechenden Rückmeldung vom Vergleicher 7 an die Eingabeeinheit 9 die Referenzspannung am Referenzeingang des Vergleichers 7 auf ein Signal von der Bedieneinheit 9 hin auf eine zweite Refernzspannung U2 erniedrigt. Die Höhe der zweiten Refernzspannung U2 errechnet sich aus der Reihenschaltung der anzuschließenden Impedanz 5 und des Widerstandes 4, wobei ein noch tolerierbarer Kontaktwiderstand in Form einer geringfügigen weiteren Absenkung der Referenzspannung U2 in Höhe weniger Prozent berücksichtigt wird. Bei Überschreiten dieser zweiten Referenzspannung U2 durch die am Meßwiderstand 4 anstehende Spannung detektiert der Vergleicher 7 den ordnungsgemäßen Anschluß der Impedanz 5, und das Prüfprogramm wird nach Abgabe eines entsprechenden zweiten Signals 52 abgebrochen. Unterschreitet die am Meßeingang des Vergleichers 7 anstehende Spannung die zweite Referenzspannung U2, so wird die Ausgangsspannung der Referenzspannungsquelle 8 auf eine dritte Referenzspannung U3 erniedrigt. Der Wert dieser dritten Referenzspannung U3 ergibt sich aus dem Wert, der sich aus dem gänzlichen Fehlen einer Last am Verstärkerausgang einstellt zuzüglich weniger Prozent. Wird diese dritte Referenzspannung U3 durch die sich am Meßwiderstand 4 einstellende Spannung überschritten, so erkennt der Vergleicher einen erhöhten Wert der angeschlossenen Impedanz 5, wie er sich beispielsweise aus korrodierten Steckkontakten in Kraftfahrzeugen ergibt, und gibt über die Ausgabeeinheit 10 ein entsprechendes drittes Signal 53 ab. Bei Unterschreiten der dritten Referenzspannung wird ein Leerlauf detektiert, d. h. an die Brückenendstufe 1 ist keine Last angeschlossen. Nach Abgabe eines entsprechenden vierten Signals 54 über die Ausgabeeinheit 10 wird das Prüfprogramm beendet. Durch Aufnahme weiterer Referenzspannungswerte in das Prüfprogramm lassen sich ggf. weitere Fehlerfälle unterscheiden.

## Patentansprüche

1. Verfahren zur Prüfung des korrekten Anschlusses einer Impedanz (5), insbesondere der Impedanz eines Lautsprechers, an eine aus zwei Halbbrücken in Form von Verstärkern (2,3) bestehende Brückenendstufe (1), wobei die Impedanz (5) in der Brückendiagonale zwischen den beiden Halbbrücken der Brückenendstufe angeschlossen ist, wobei die Brückendiagonale durch Veränderung des Arbeitspunktes einer Halbbrücke aus dem Gleichgewicht gebracht wird, wobei der in Folge des Ungleichgewichts der Brückendiagonale durch die Impedanz (5) fließende Strom in Form einer über einem zur Impedanz (5) in Serie geschalteten Messwiderstand (4) abfallenden Spannung gemessen wird, wobei die über dem Messwiderstand (4) abfallende Spannung in einem Vergleicher (7) mit einer Referenzspannung verglichen wird, und wobei der korrekte Anschluss der Impedanz (5) durch den Vergleich der am Messwiderstand (4) abfallenden Spannung mit der Referenzspannung bestimmt wird.

2. Verfahren nach Anspruch 1, **dadurch gekennzeichnet, dass** der Arbeitspunkt einer Halbbrücke über einen steuerbaren Schalter (11) auf ein gemeinsames Bezugspotential abgesenkt wird.

3. Verfahren nach Anspruch 1, **dadurch gekennzeichnet, dass** der Arbeitspunkt einer Halbbrücke mittels eines steuerbaren Schalters (11) und eines dazu in Serie geschalteten Widerstandes (14) auf ein vorgegebenes Potential abgesenkt wird.

4. Verfahren nach einem der Ansprüche 1 bis 3, **dadurch gekennzeichnet, dass** dem Vergleicher (7) verschiedene Referenzspannungswerte zugeführt werden.

5. Verfahren nach einem der Ansprüche 1 bis 4, **dadurch gekennzeichnet, dass** das Ausgangssignal des Vergleichers (7) über eine Ausgabeeinheit (10), vorzugsweise über ein optisches Anzeigeinstrument oder einen akustischen Signalgeber ausgegeben wird.

6. Anordnung zur Prüfung des korrekten Anschlusses einer Impedanz (5), insbesondere der Impedanz eines Lautsprechers, an eine aus zwei Halbbrücken in Form von Verstärkern (2,3) bestehende Brückenendstufe (1), wobei die Impedanz (5) in der Brückendiagonale zwischen den beiden Halbbrücken der Brückenendstufe angeschlossen ist, wobei der der Arbeitspunkteinstellung dienende Eingang einer der beiden Halbbrücken (2 oder 3) der Brückenendstufe (1) über einen steuerbaren Schalter (11) mit einem gemeinsamen Bezugspotential verbindbar ist, wobei der in Folge des Ungleichgewichts der Brückendiagonalen durch die Impedanz (5) fließende Strom in Form einer über einem zur Impedanz (5) in Serie geschalteten Messwiderstand (4) abfallenden Spannung einem Eingang eines Vergleichers (7) zugeführt ist, dessen zweiter Eingang mit einer Referenzspannungsquelle (8) verbunden ist, und wobei das Ausgangssignal des Vergleichers (7) zur Bestimmung des korrekten Anschlusses der Impedanz (5) an der Brückenendstufe verwendbar ist.

7. Anordnung nach Anspruch 6, **dadurch gekennzeichnet, dass** der Ausgang des Vergleichers (7) mit einer Ausgabeeinheit (10), vorzugsweise einem optischen Anzeigeinstrument und/oder einem akustischen Signalgeber verbunden ist.

8. Anordnung nach Anspruch 6 oder 7, **dadurch gekennzeichnet, dass** dem steuerbaren Schalter (11) ein zusätzlicher dritter Widerstand (14) in Serie geschaltet ist.

## Claims

1. Method for checking the correct connection of an impedance (5), in particular the impedance of a loudspeaker, to a bridge output stage (1) comprising two half-bridges in the form of amplifiers (2, 3), the impedance (5) being connected in the bridge diagonal between the two half-bridges of the bridge output stage, the bridge diagonal being brought out of equilibrium by altering the operating point of one half-bridge, the current flowing through the impedance (5) as a result of the lack of equilibrium in the bridge diagonal being measured in the form of a voltage drop across a measuring resistor (4) connected in series with the impedance (5), the voltage drop across the measuring resistor (4) being compared in a comparator (7) with a reference voltage, and the correct connection of the impedance (5) being determined by the comparison of the voltage drop across the measuring resistor (4) with the reference voltage.

2. Method according to Claim 1, **characterized in that** the operating point of one half-bridge is reduced to a common reference potential by means of a controllable switch (11).

3. Method according to Claim 1, **characterized in that** the operating point of one half-bridge is reduced to a predetermined potential by means of a controllable switch (11) and a resistor (14) connected in series with said controllable switch (11).

4. Method according to one of Claims 1 to 3, **characterized in that** different reference voltage values are supplied to the comparator (7).

5. Method according to one of Claims 1 to 4, **characterized in that** the output signal of the comparator (7) is output via an output unit (10), preferably via an optical display instrument or an audible signal emitter.

6. Arrangement for checking the correct connection of an impedance (5), in particular the impedance of a loudspeaker, to a bridge output stage (1) comprising two half-bridges in the form of amplifiers (2, 3), the impedance (5) being connected in the bridge diagonal between the two half-bridges of the bridge output stage, it being possible for the input, which serves to set the operating point, of one of the two half-bridges (2 or 3) of the bridge output stage (1) to be connected to a common reference potential via a controllable switch (11), the current flowing through the impedance (5) as a result of the lack of equilibrium in the bridge diagonal being supplied to an input of a comparator (7) in the form of a voltage drop across a measuring resistor (4) connected in series with the impedance (5), the second input of said comparator (7) being connected to a reference voltage source (8), and it being possible for the output signal of the comparator (7) to be used to determine the correct connection of the impedance (5) to the bridge output stage.

7. Arrangement according to Claim 6, **characterized in that** the output of the comparator (7) is connected to an output unit (10), preferably an optical display instrument and/or an audible signal emitter.

8. Arrangement according to Claim 6 or 7, **characterized in that** an additional, third resistor (14) is connected in series with the controllable switch (11).

## Revendications

1. Procédé de vérification du raccordement correct d'une impédance (5), et notamment de l'impédance d'un haut-parleur, à un étage de sortie en pont (1) constitué de deux demi-ponts en forme d'amplificateurs (2,3),
dans lequel l'impédance (5) est raccordée dans la diagonale du pont entre les deux demi-ponts de l'étage de sortie du pont,
dans lequel la diagonale du pont est déséquilibrée par la modification du point de fonctionnement dynamique d'un demi-pont,
dans lequel le courant, circulant à travers l'impédance (5) à la suite du déséquilibre de la diagonale du pont, est mesuré sous la forme d'une tension retombant au passage d'une résistance de mesure (4) montée en série avec l'impédance (5),
dans lequel la tension retombant au passage de la résistance de mesure (4) est comparée à une tension de référence dans un comparateur (7),
et dans lequel le raccordement correct de l'impédance (5) est déterminé par comparaison de la tension retombant au passage de la résistance de mesure (4) avec la tension de référence.

2. Procédé selon la revendication 1,
**caractérisé en ce que**
le point de fonctionnement dynamique d'un demi-pont est abaissé, par l'intermédiaire d'un interrupteur réglable (11), jusqu'à un potentiel de référence commun.

3. Procédé selon la revendication 1,
**caractérisé en ce que**
le point de fonctionnement dynamique d'un demi-pont est abaissé, par l'intermédiaire d'un interrupteur réglable (11) et d'une résistance (14) montée en série avec celui-ci, jusqu'à un potentiel prédéterminé.

4. Procédé selon l'une des revendications 1 à 3,
**caractérisé en ce que**
différentes valeurs de tension de référence sont amenées au comparateur (7).

5. Procédé selon l'une des revendications 1 à 4,
**caractérisé en ce que**
le signal de sortie du comparateur (7) est émis par l'intermédiaire d'une unité d'émission (10), et de préférence d'un instrument d'affichage optique ou d'un poste transmetteur de signaux acoustiques.

6. Procédé de vérification du raccordement correct d'une impédance (5), et notamment de l'impédance d'un haut-parleur, à un étage de sortie en pont (1) constitué de deux demi-ponts en forme d'amplificateurs (2,3),
dans lequel l'impédance (5) est raccordée dans la diagonale du pont entre les deux demi-ponts de l'étage de sortie du pont,
dans lequel l'entrée, servant au réglage du point dynamique de fonctionnement, de l'un des deux demi-ponts (2 ou 3) de l'étage de sortie du pont (1) peut être raccordée, par l'intermédiaire d'un interrupteur réglable (11), à un potentiel de référence commun,
dans lequel le courant circulant à travers l'impédance (5) à la suite du déséquilibre de la diagonale du pont est amené, sous la forme d'une tension retombant au passage d'une résistance de mesure (4) montée en série avec l'impédance (5), à une entrée d'un comparateur (7) dont la seconde entrée est raccordée à une source de tension de référence (8),
et dans lequel le signal de sortie du comparateur (7) peut être utilisé pour déterminer le raccordement correct de l'impédance (5) à l'étage de sortie du pont.

7. Procédé selon la revendication 6,
**caractérisé en ce que**
la sortie du comparateur (7) est raccordée à une unité d'émission (10), et de préférence à un instrument d'affichage optique ou à un poste transmetteur de signaux acoustiques.

8. Procédé selon la revendication 6 ou 7,
**caractérisé en ce que**,
à titre additionnel, une troisième résistance (14) est montée en série avec l'interrupteur réglable (11).
